(19) Europäisches Patentamt
European Patent Office
Office européen des brevets

(11) **EP 2 332 882 B1**

(12) **FASCICULE DE BREVET EUROPEEN**

(45) Date de publication et mention
de la délivrance du brevet:
**04.07.2012 Bulletin 2012/27**

(51) Int Cl.:
***B81C 1/00*** *(2006.01)*

(21) Numéro de dépôt: **10354080.3**

(22) Date de dépôt: **22.11.2010**

(54) **Procédé de réalisation d'un revêtement de surface contrôlé tridimensionnellement dans une cavité**

Herstellungsverfahren einer dreidimensionalen kontrollierten Oberflächenbeschichtung in einem Hohlraum

Method for forming a three-dimensionally controlled surface coating inside a cavity

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.12.2009 FR 0905975**

(43) Date de publication de la demande:
**15.06.2011 Bulletin 2011/24**

(73) Titulaire: **Commissariat à l'Énergie Atomique et aux Énergies Alternatives**
**75015 Paris (FR)**

(72) Inventeurs:
• **Wacquez, Romain**
**38000 Grenoble (FR)**

• **Constancias, Christophe**
**38700 Sarcenas (FR)**
• **Coronel, Philippe**
**38530 Barraux (FR)**

(74) Mandataire: **Talbot, Alexandre et al**
**Cabinet Hecké**
**Europole, BP 1537**
**10, rue d'Arménie**
**38025 Grenoble Cedex 1 (FR)**

(56) Documents cités:
**WO-A1-03/096368        JP-A- 2007 156 384**
**US-A1- 2004 265 182**

## Description

### Domaine technique de l'invention

L'invention est relative à un procédé de réalisation d'une cavité ayant des première et seconde parois principales opposées, l'une des parois principales étant partiellement recouverte par un revêtement de surface de taille submicronique ayant une face libre.

### État de la technique

Dans le domaine de l'industrie microélectronique et nanoélectronique, les dispositifs réalisés utilisent des propriétés bien spécifiques des matériaux qui les constituent. Les propriétés de surface et de volume conditionnent l'obtention d'un dispositif qui répond ou non à des contraintes prédéfinies. Il est donc important d'avoir un parfait contrôle dimensionnel des différents éléments constitutifs des dispositifs ainsi qu'une parfaite maîtrise des propriétés de surface ou de volume des matériaux utilisés. Le choix des couches de revêtement de surface qui permettent de spécialiser ou de protéger une partie de la surface utilisée est alors d'une très grande importance.

Afin de poursuivre la course à la performance, il est nécessaire de disposer de dispositifs toujours plus petits. Pour obtenir des dispositifs qui répondent à des contraintes toujours plus sévères, il faut être en mesure de localiser précisément les matériaux à la surface du substrat et de maîtriser leur position, leur épaisseur et leurs dimensions latérales. Cependant pour être efficaces, ces revêtements de surface doivent être parfaitement contrôlés dans leur position et dans leurs dimensions (alignement et auto-alignement).

Afin de pouvoir continuer la course à la miniaturisation et à la spécialisation, il devient important de pouvoir définir ces couches aux propriétés particulières à la surface d'un substrat, mais également dans des cavités ou des zones difficiles d'accès.

Le revêtement de surface qui est devenu un élément primordial du dispositif est formé en même temps que le dispositif à un moment du procédé où il est facile de définir le revêtement de surface et quand ce dernier ne sera plus susceptible d'être détérioré par les étapes postérieures. Le revêtement de surface est formé en même temps que la cavité, ou avant la cavité du dispositif car après, il n'est plus possible d'assurer la localisation et la définition exacte des dimensions du revêtement de surface.

Classiquement, le revêtement de surface est formé sur la face visible du substrat à l'emplacement de la future cavité, ou dans une variante, le revêtement de surface est réalisé sur un film annexe qui est reporté par la suite pour réaliser le scellement de la cavité.

Ces procédés sont difficiles à mettre en oeuvre. Il est nécessaire d'utiliser des procédés de réalisation qui sont plus compliqués avec des contraintes physico-chimiques importantes entre les matériaux. Il faut utiliser différentes astuces de réalisation afin de pouvoir commencer la formation de la cavité tout en étant capable de former dans une zone particulière un revêtement de surface qui ne sera pas éliminé ou détérioré par une étape postérieure. Il est également difficile d'atteindre des densités d'intégration élevées car la complexité du procédé de réalisation va de pair avec une augmentation des marges de sécurité tant au niveau de la photolithographie que dans les épaisseurs des couches utilisées.

De plus, le revêtement de surface étant formé pendant ou avant la cavité et donc avant la formation de la paroi supérieure, il est difficile voire impossible de corriger les variations du procédé de réalisation qui aboutissent, par exemple, à une différence de hauteur dans la cavité ou à un décalage de position et donc à un décalage dans le fonctionnement final du dispositif.

Le document US 2004/265182 A1 décrit un procédé de réalisation d'une cavité ayant des première et seconde parois principales opposées, le procédé comportant une étape d'insolation d'un polymère photosensible sur une première épaisseur par un rayonnement pour former dans ce polymère photosensible une première zone en matériau sacrificiel et une seconde zone de nature différente, la seconde zone de nature différente définissant une paroi de la cavité. Le matériau sacrificiel est ultérieurement éliminée dans la première zone, et ce pour aboutir à un canal de type micro-fluidique partiellement fermé.

### Objet de l'invention

L'invention a pour objet un procédé qui permet de localiser facilement un revêtement de surface et d'assurer un parfait contrôle dimensionnel de la zone en revêtement de surface.

Le procédé selon l'invention est caractérisé par les revendications annexées et plus particulièrement par le fait qu'il comporte :

- la formation de la cavité avec ses deux parois principales recouvertes par une résine,
- l'insolation d'une première épaisseur de la résine par un rayonnement, au travers de la première paroi principale, pour former dans la résine une première zone en matériau sacrificiel et une seconde zone de nature différente, l'une des première et seconde zones définissant, l'aire du futur revêtement de surface,
- l'élimination du matériau sacrificiel,
- la formation du revêtement de surface contre une des parois principales.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels

- les figures 1 à 3 représentent, de manière schématique, en coupe, une cavité recouverte ou remplie par une résine selon différents modes de réalisation de l'invention,
- la figure 4 représente, de manière schématique, en coupe, une cavité remplie par une résine et un matériau de remplissage selon l'invention,
- les figures 5 et 6 représentent, de manière schématique, en coupe, l'insolation de la résine dans la cavité selon l'invention,
- les figures 7 à 19 représentent, de manière schématique, en coupe, différentes étapes pour la localisation du revêtement de surface dans la cavité selon différents modes de réalisation de l'invention.

## Description de modes de réalisation préférentiels de l'invention

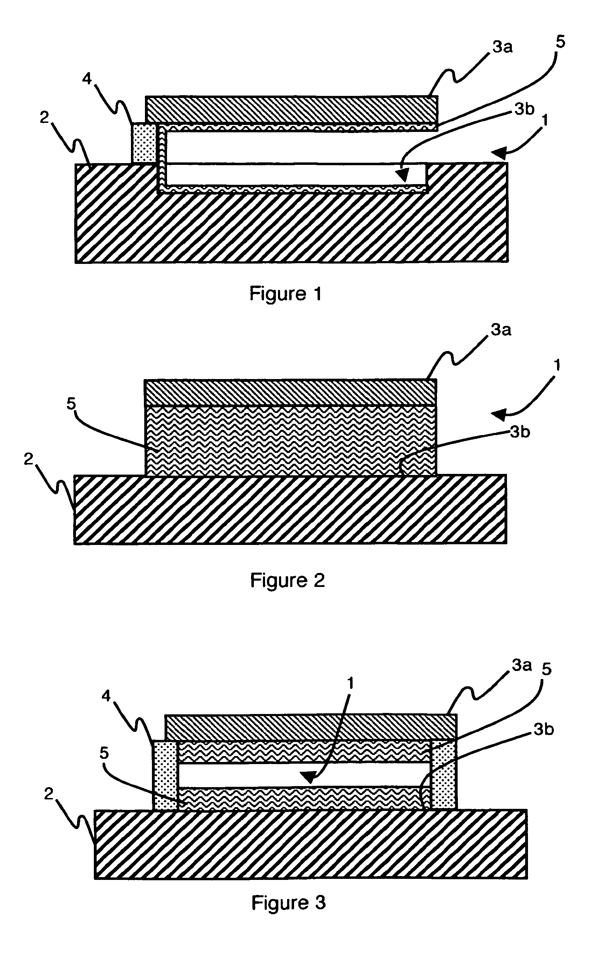

Comme illustré à la figure 1, une cavité 1 est formée dans un substrat 2. La cavité 1 est délimitée au moins par deux parois principales 3 opposées, une première paroi principale 3a et une seconde paroi principale 3b. La première paroi principale 3a et la seconde paroi principale 3b sont séparées d'une distance prédéfinie, la hauteur, cette distance peut varier sur l'ensemble de la surface de la cavité 1. Ainsi, la hauteur de la cavité 1 peut varier en tout point selon les formes des première 3a et seconde 3b parois principales et leurs orientations respectives. Les première 3a et seconde 3b parois principales sont avantageusement planes mais elles peuvent présenter une topographie de surface, c'est-à-dire une différence de niveau entre différentes zones, par exemple une structuration de surface, une différence d'épaisseur.

La première paroi principale 3a est maintenue à distance de la seconde paroi principale 3b par tout moyen adapté, par exemple par l'utilisation d'une ou plusieurs parois latérales 4 ou au moyen d'un bras de support. La première paroi principale 3a peut être mobile par rapport à la seconde paroi principale 3b ou inversement. La cavité 1 peut être une cavité ouverte, c'est-à-dire une cavité 1 qui présente une zone d'accès au volume disposé entre les deux parois principales opposées 3, ou une cavité fermée dans laquelle il n'y a pas d'accès au volume disposé entre les parois principales opposées 3.

Comme illustré à la figure 2, la cavité 1 peut donc être une cavité complètement ouverte dans laquelle la délimitation latérale de la cavité 1 est réalisée au moyen de la surface de la première paroi principale 3a. Dans ce cas, le volume de la cavité est défini par rapport au dessin de la première paroi principale 3a, il n'y a pas de parois latérales physiques délimitant le volume de la cavité 1. La cavité 1 représente donc le volume libre qui est localisé entre les deux parois principales 3a et 3b.

La cavité 1 peut également être une cavité partiellement ouverte (figure 1) dans laquelle la délimitation latérale de la cavité 1 est réalisée au moyen de la surface de la paroi principale supérieure 3a et d'au moins une paroi latérale 4. Dans une cavité 1 partiellement ouverte, il est possible d'avoir une délimitation latérale physique de la cavité 1 au moyen de parois latérales 4 et un accès au volume de la cavité 1 au moyen d'une ouverture formée dans la première paroi principale 3a, la seconde paroi principale 3b ou au moyen d'une paroi latérale 4 absente ou trouée.

Comme illustré à la figure 3, il est également envisageable d'avoir une cavité 1 complètement fermée, c'est-à-dire une cavité dont on ne peut avoir accès à son volume intérieur.

La cavité 1 est obtenue par tout moyen adapté. La hauteur de la cavité 1 est comprise dans une gamme allant de quelques nanomètres à quelques centaines de micromètres, de préférence entre 50 et 100$\mu$m pour éviter les problèmes de tenue mécanique. Il en va de même des dimensions latérales de la cavité 1 qui peuvent atteindre exceptionnellement quelques dizaines de micromètres. Avantageusement, la cavité 1 présente des dimensions nanométriques ou sub-micrométriques, ainsi la largeur et la longueur de la cavité 1 sont comprises dans une gamme allant de quelques nanomètres à un micromètre. Typiquement, la distance séparant les parois principales 3 opposées est comprise entre 10 et 50 nm. La forme de la première paroi principale 3a de la cavité est quelconque, elle peut être par exemple carrée, rectangulaire, ronde ou ovale.

Les parois de la cavité 1 sont recouvertes par une couche de résine 5. Dans le cas d'une cavité 1 complètement ou partiellement ouverte, il est avantageux de déposer la résine 5 par les ouvertures de la cavité 1 afin de recouvrir au moins les parois principales 3 de la cavité 1. Selon les techniques de dépôt utilisées et les ouvertures présentes, la résine 5 peut n'être déposée que sur les parois 3, 4 de la cavité 1 et laisser un volume vide dans la cavité 1 ou dans un autre cas, la résine 5 peut remplir complètement tout le volume de la cavité 1.

Typiquement, si la résine 5 est déposée par une technique à la tournette, la résine 5 remplit tout le volume de la cavité 1. Dans le cas où la résine 5 est déposée par une technique de dépôt chimique en phase vapeur, la résine 5 se dépose sur les parois de la cavité et selon l'épaisseur déposée, elle peut laisser libre une partie du volume de la cavité ou remplir la cavité 1. Si la résine 5 doit être déposée sur les parois principales de la cavité avec une épaisseur faible, c'est-à-dire une épaisseur telle que la cavité 1 n'est pas remplie par la résine 5, il est avantageux de déposer la résine 5 par une technique de dépôt chimique en phase vapeur.

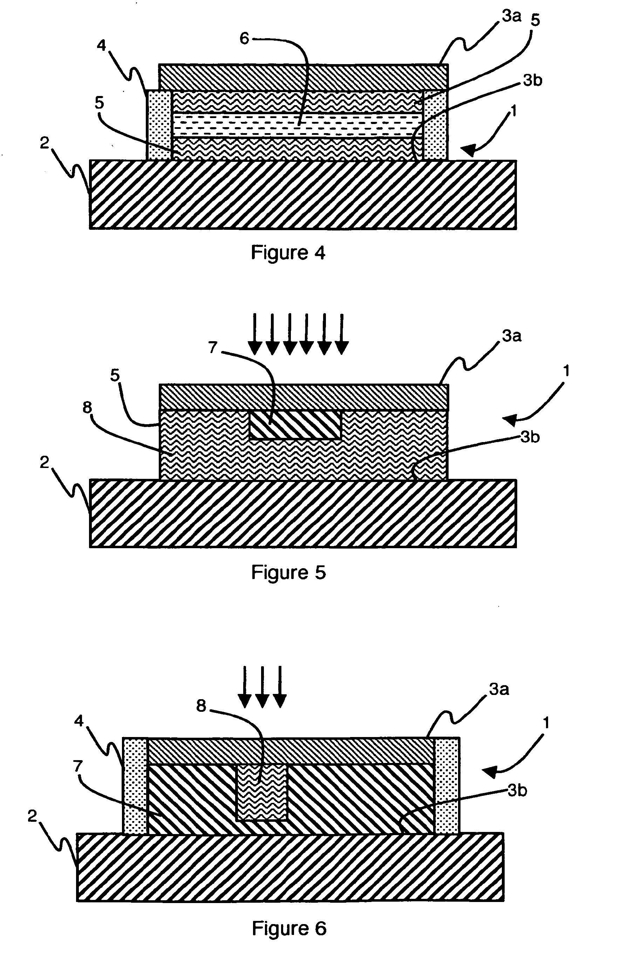

Après le dépôt de la résine 5, si il existe un volume vide dans la cavité 1, ce dernier peut être laissé vide ou être rempli au moyen d'un matériau de remplissage 6, illustré à la figure 4, ayant des propriétés physicochimiques différentes de celles de la résine 5. Typiquement, le matériau de remplissage 6 n'est pas réactif au rayonnement utilisé par la suite et il peut être éliminé sélectivement par rapport à la résine 5. Le matériau de remplissage 6 est, par exemple, un matériau déposé de manière conforme et fluable à basse température, typiquement une encre isolante ou conductrice.

Si la cavité 1 est une cavité fermée (figures 3, 4 et 6), la résine 5 a été déposée lors de la formation de la cavité 1. Par exemple, la résine 5 a été déposée dans une rainure ou un trou qui a été recouvert par la suite par une des parois principales 3. Dans ce cas de figure, la résine 5 recouvre bien les parois principales 3 de la cavité 1 car les parois ont été formées sur le motif en résine 5. Dans la cavité 1, il peut exister un multicouche dans laquelle au moins deux couches en résine 5 sont séparées par un matériau de remplissage 6 (figure 4).

Comme illustré à la figure 5, une fois la cavité 1 formée avec ses parois principales 3 recouvertes par la résine 5, la cavité 1 et la résine 5 sont soumises à rayonnement électronique ou à un rayonnement électromagnétique afin de faire réagir une partie du volume de la résine 5 disposée dans la cavité 1. L'insolation de la résine 5 est réalisée au moyen d'un rayonnement électronique faiblement énergétique ou au moyen d'un rayonnement électromagnétique dont la longueur d'onde est comprise entre 0,1 et 40nm et de préférence entre 12,5 et 15nm pour pouvoir travailler facilement par exemple avec les matériaux à base de silicium. Si la cavité a une hauteur inférieure à 500nm, le rayonnement électronique a, de préférence, une énergie comprise entre 0,1 et 10keV. Si la cavité a une hauteur supérieure, l'énergie est augmentée et pour une cavité ayant une hauteur de l'ordre de 10$\mu$m, il faut une énergie de l'ordre de 100keV. Ce type de rayonnement permet de définir latéralement des motifs de taille nanométrique, typiquement de l'ordre d'une dizaine de nanomètres, ainsi que des motifs de l'ordre d'une centaine de nanomètres. Le rayonnement permet de former des motifs de taille sub-nanométrique dans la résine 5 qui sont en adéquation avec les dimensions de la cavité 1.

Afin de spécialiser la surface interne de la cavité 1 seulement une partie de la résine 5 est insolée, c'est-à-dire transformée dans un matériau différent. De cette manière, il existe dans la cavité 1 différentes portions qui ont des propriétés électriques, optiques physico-chimiques et/ou mécaniques différentes. C'est cette différence de propriétés entre les deux zones de la cavité 1 qui est utilisée par la suite par le dispositif directement ou indirectement.

Les matériaux constituant la résine 5 sont choisis de manière à réagir avec le rayonnement incident et réaliser ainsi l'insolation partielle de la résine 5. La résine est donc dans un matériau sensible au rayonnement électronique ou au rayonnement électromagnétique ayant une longueur d'onde comprise entre 12,5 et 15nm. La résine est par exemple en hydrogen silsesquioxane (HSQ), ou en polyméthacrylate de méthyle PMMA ou à base d'organométallique, par exemple une résine commercialisée par la société CEIMIG et qui donne un matériau stable métallique comme l'or ou le platine, ou un

oxyde métallique comme $Al_2O_3$, ZnO, et $TiO_2$ et un oxyde métallique mélangé à base de BaTiO3, d'oxyde d'indium-étain ou de titano zirconate de plomb (PZT).

Afin de réaliser l'insolation de la résine 5 à travers la première paroi principale 3a de la cavité, il est nécessaire que le ou les matériaux constituant la première paroi principale 3a de la cavité soient transparents ou au moins partiellement transparents au rayonnement utilisé. Les matériaux formant la première paroi principale 3a et les conditions opératoires du rayonnement indicent sont choisis pour obtenir l'insolation d'une première épaisseur d'au moins une partie de la résine 5 disposée dans la cavité, à travers la première paroi principale 3a. Cette première épaisseur de résine insolée est inférieure à la hauteur de la cavité.

Comme illustré aux figures 5 et 6, lors de l'insolation (symbolisée par des flèches sur les figures) de la résine 5 et selon la polarité de la résine utilisée, cette dernière est transformée soit en un matériau sacrificiel 7 (figure 5), soit en matériau stable 8, c'est-à-dire un matériau qui présente une autre nature que la matériau sacrificiel 7. Selon les modes de réalisation le matériau stable 8 va délimiter ou former le revêtement de surface 9. De ce fait, le rayonnement définit au moins, dans la résine 5, une première zone en matériau sacrificiel 7 et une seconde zone de nature différente 8 qui peut être conservée, transformée ou éliminée plus tard. L'une des première et seconde zones permet de définir le revêtement de surface 9, c'est-à-dire d'assurer la délimitation tridimensionnelle du revêtement de surface 9 dans la cavité. L'insolation forme alors des première et seconde zones et au moins l'une de ces première et seconde zones a une épaisseur égale à la première épaisseur d'insolation, c'est-à-dire la première épaisseur transformée de résine 5. L'insolation de la résine 5 permet de définir un matériau sacrificiel 7 et un matériau stable 8 que la résine soit de polarité négative ou positive. Selon la polarité de la résine utilisée, il n'y a que l'effet de l'insolation qui change en formant dans la zone insolée soit le matériau sacrificiel 7, soit le matériau stable 8. Dans le mode de réalisation illustré à la figure 5, l'insolation de la résine 5 modifie sa structure alors que ce n'est pas le cas dans la figure 6.

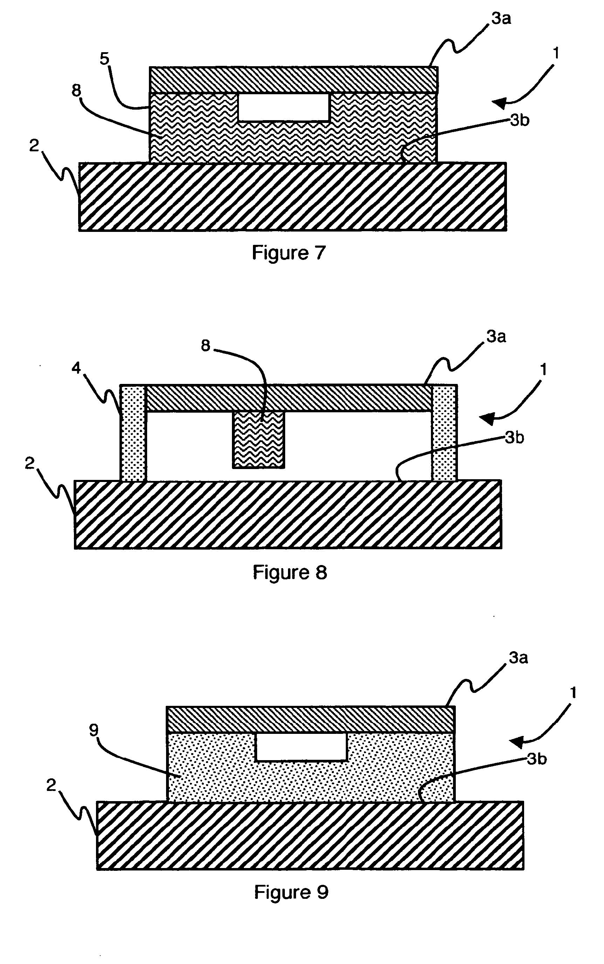

Comme illustré aux figures 7 et 8, une fois l'insolation réalisée, le matériau sacrificiel 7 est éliminé. L'élimination est réalisée par toute technique adaptée et le retrait du matériau sacrificiel 7 est réalisé au travers de la ou des ouvertures qui existent dans la cavité. Si la cavité 1 est une cavité fermée, il est avantageux de former au moins une ouverture pour éliminer le matériau sacrificiel. Il est également possible, selon les procédés et les matériaux utilisés, de réaliser l'élimination du matériau sacrificiel à travers une des parois de la cavité même s'il n'existe pas d'ouverture. Après l'élimination du matériau sacrificiel 7, le revêtement de surface 9 est formé et la cavité 1 peut ensuite être laissée en l'état ou alors elle peut être modifiée pour former une cavité fermée ou une cavité complètement ou partiellement ouverte. Les modes de réalisation illustrés aux figures 7. et 8 peuvent provenir des étapes antérieures illustrées respectivement aux figures 5 et 6.

Une fois le matériau sacrificiel éliminé, il ne reste plus qu'une partie de la résine 5 (le matériau stable 8) qui délimite le revêtement de surface. Le matériau stable 8 permet de délimiter le revêtement de surface 9 qui est en contact avec une des parois principales 3 sur une première face alors que la seconde face opposée est libre.

Cette face libre peut être utilisée pour ses propriétés de surfaces ou de volume et/ou pour réduire la distance effective qui sépare les première 3a et seconde 3b parois principales.

Dans un mode particulier de réalisation illustré aux figures 7 et 8, le matériau stable 8 forme le matériau du revêtement de surface 9 directement après l'élimination du matériau sacrificiel 7, la zone en revêtement de surface 9 est directement définie dans ses dimensions par le rayonnement utilisée. Le revêtement de surface 9 est réalisé par le matériau stable 8 ce qui permet de limiter les étapes technologiques.

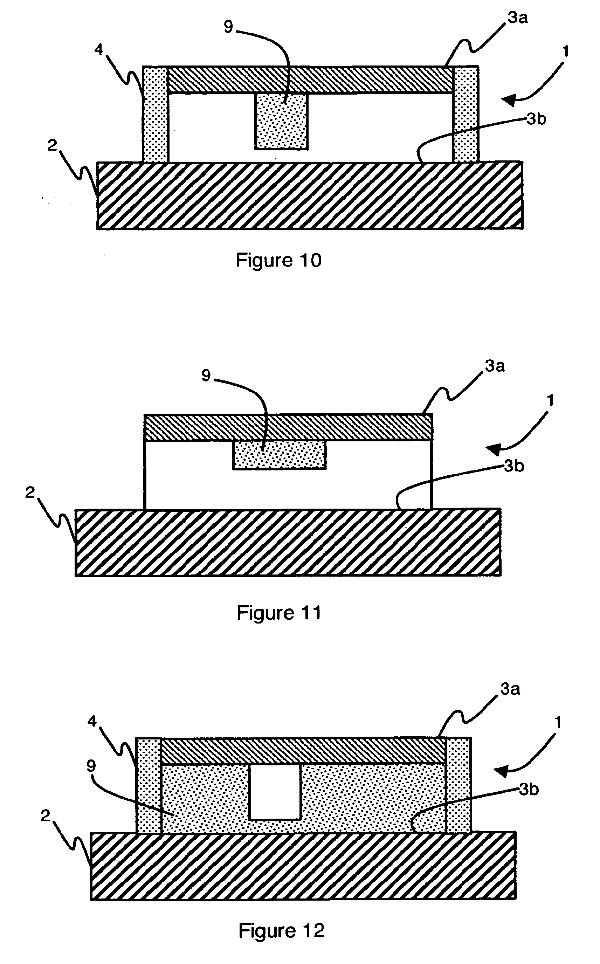

Dans une autre variante de réalisation illustrée également aux figures 9 et 10, le matériau stable 8 forme le revêtement de surface 9 après avoir subi une étape additionnelle de traitement thermique ou de traitement plasma, par exemple la transformation de la résine HSQ (hydrogen silsesquioxane) en un oxyde de silicium, il est possible d'avoir une modification du volume entre le revêtement de surface 9 et le matériau stable 8. Cette modification des dimensions est prise en compte lors de la définition des première et seconde zones dans la résine 5. Le revêtement de surface 9 est alors réalisé par un matériau qui provient du matériau stable 8 après une étape de transformation. Ce mode de réalisation permet de modifier les propriétés intrinsèques du matériau stable 8 tout en conservant les avantages de définition directe du revêtement de surface par le rayonnement (rapidité, précision). Les modes de réalisation illustrés aux figures 9 et 10 peuvent provenir des étapes antérieures illustrées respectivement aux figures 7 et 8.

Il est également envisageable, dans une autre de réalisation illustrée aux figures 11 et 12, d'utiliser la zone vide formée dans la cavité 1 après l'élimination du matériau sacrificiel 7 pour effectuer la délimitation du revêtement de surface 9. Dans ce cas, le revêtement de surface 9 est formé dans la première zone en matériau sacrificiel 7 après élimination du matériau sacrificiel et le revêtement de surface 9 remplit le volume laissé vide. Le revêtement de surface est donc contrôlé dans ses dimensions au moyen du rayonnement par l'intermédiaire du matériau stable 8 qui sert de moule. Ce mode de réalisation est particulièrement avantageux quand il est impossible ou difficile d'obtenir une résine présentant la polarité recherchée et/ou les caractéristiques recherchées (optiques, électriques...). Les modes de réalisation illustrés aux figures 11 et 12 peuvent provenir des étapes antérieures illustrées respectivement aux figures 9 et 10.

Dans tous les cas, le revêtement de surface 9 est contre une des parois principales 3 et il possède une face libre. La face libre est à distance de la paroi principale 3 opposée et peut être en contact avec un fluide. La face libre est en vis-à-vis avec une des parois principales, mais selon la forme du revêtement de surface, la face libre peut également être en vis-à-vis d'une paroi latérale. Le rayonnement définissant au moins une zone en matériau sacrificiel 7, la cavité 1 est partiellement recouverte par une zone en revêtement de surface 9 et au moins une partie de la première paroi principale 3a et/ou de la seconde paroi principale 3b est libre après l'élimination du matériau sacrificiel 7 ou élimination du matériau stable 8 délimitant le revêtement de surface 9. Dans tous les cas de figure, le revêtement de surface 9 ne recouvre pas l'ensemble des parois de la cavité 1.

Le revêtement de surface 9 est localisé dans la cavité 1 sur une des parois principales 3 de la cavité, soit la paroi principale supérieure 3a, soit la paroi principale inférieure 3b soit sur les deux parois principales 3. Le revêtement de surface 9 est délimité dans la cavité 1 au moyen de la résine 5 et du rayonnement modifiant une partie de la résine 5 soit de manière directe soit de manière complémentaire. Le choix de la technique de délimitation du revêtement de surface est réalisée en fonction de la polarité de la résine, de sa fonctionnalité (caractéristiques mécaniques, optiques, électriques physico-chimiques recherchées), des dimension voulues pour le revêtement de surface et des conditions opératoires du rayonnement.

Dans un mode de réalisation particulier, le revêtement de surface 9 peut recouvrir l'intégralité de la surface interne d'une des parois principale 3 (figures 9, 12, 14, 18 et 19) ou seulement une zone spécifique (figures 11, 13 et 15 à 17). Il est également possible que le revêtement de surface 9 soit présent sur les deux parois principales opposées 3 mais seulement sur une partie de ces parois. Cette différence dans l'étendue et la localisation du revêtement de surface provient de la zone insolée de la résine et donc du volume de la portion de cavité soumise au rayonnement et/ou de l'absorption de ce rayonnement par la cavité.

Ainsi, une partie de la surface intérieure de la cavité 1 est recouverte par le revêtement de surface 9. Le revêtement de surface 9 est délimité latéralement de manière positive ou négative au moyen du rayon incident par rapport au volume de résine 5 insolé. Cette technique permet donc de définir parfaitement la position et les dimensions latérales du revêtement de surface 9 dans une zone difficile d'accès et sans modifier les propriétés physico-chimiques de la première paroi principale 3a et de la seconde paroi principales 3b. Afin d'assurer un bon contrôle des propriétés électriques, mécaniques, optiques ou physico-chimiques dans la cavité 1, il est également nécessaire de maîtriser la forme du revêtement de surface 9 et donc son épaisseur ou l'évolution de son épaisseur le long de sa surface.

Une première manière de contrôler l'épaisseur du revêtement de surface 9 est de contrôler l'épaisseur de la résine 5 qui va délimiter le revêtement de surface. Dans ce cas, l'intégralité de la résine 5 soumise au rayonnement est insolée et les variations d'épaisseur lors du dépôt de résine 5 sont retranscrites dans le revêtement de surface. Ce mode de réalisation illustré à la figure 1 est particulièrement intéressant si l'on souhaite former deux motifs identiques se faisant faces sur les parois principales 3 de la cavité 1.

Une seconde manière de contrôler l'épaisseur du revêtement de surface 9 est de contrôler le profil d'absorption du rayonnement dans la cavité 1. L'épaisseur de revêtement de surface 9 est définie à l'intérieur de l'épaisseur de la résine 5 (figures 5 et 6). L'épaisseur du futur revêtement de surface 9 correspond à la première épaisseur insolée de la résine 5 ou à la partie complémentaire de l'épaisseur insolée. Il n'est plus absolument nécessaire de travailler avec une première paroi principale 3a qui est transparente au rayonnement ou considéré comme telle. Il est possible et même avantageux de travailler avec une première paroi principale 3a qui absorbe partiellement le rayonnement de manière à éviter dans certains cas de former un barreau de résine 5 sur toute l'épaisseur de la cavité. Il est également nécessaire de travailler avec une résine 5 qui absorbe partiellement le rayonnement. La résine 5 peut remplir la cavité comme illustré à la figure 2 ou elle peut laisser un volume vide comme illustré à la figure 3 ou un volume rempli par un matériau de remplissage 6 comme illustré à la figure 4.

Lorsque l'intégralité de l'épaisseur de la résine 5 est transformée dans un volume de la cavité 1, l'épaisseur du matériau insolé est contrôlée au moyen de la hauteur de la cavité ou de l'épaisseur de résine déposée. Ce n'est pas l'étape d'insolation qui réalise le contrôle dimensionnel du revêtement de surface 9. L'épaisseur de résine 5 transformée est définie au moyen de la cavité 1 et elle dépend alors des caractéristiques mécaniques des matériaux formant les parois principales 3 et du procédé de formation de la cavité 1. Selon le procédé de formation ou les conditions de dépôt de la résine 5, il peut y avoir déformation de la cavité 1 et de ce fait, l'épaisseur de résine 5 varie entre le centre et les bords de la cavité 1 alors que sans résine la cavité présente des parois principales parallèle. Une fois la résine insolée, la cavité 1 est irrémédiablement déformée. En laissant volontairement une zone vide sur une des parois principales, on peut réaliser précisément un contrôle dimensionnel sur l'épaisseur. Ce contrôle dimensionnel peut être réalisé selon les cas de figure sur la hauteur du volume vide ou sur l'épaisseur du revêtement de surface 9.

Si après élimination du matériau sacrificiel 7, la cavité 1 est remplie par au moins pilier qui contacte les deux parois principales 3 opposées, le pilier ne joue pas le rôle de revêtement de surface car il ne permet pas de fonctionnaliser une partie de la surface de la cavité 1. Le pilier retire de la surface disponible les deux zones qui lui servent de contact avec les parois principales 3.

En choisissant volontairement des matériaux absorbant le rayonnement pour former la résine 5 et éventuellement la première paroi principale 3a, il est possible de contrôler l'épaisseur de résine 5 qui est insolée et donc l'épaisseur du revêtement de surface 9. Selon la polarité de la résine 5 utilisée, l'épaisseur de résine 5 insolée correspond à l'épaisseur du revêtement de surface ou à l'épaisseur de volume vide entre le revêtement de surface et la paroi opposée. Alors que dans les conditions classiques de photolithographie, on cherche à travailler avec la résine la plus transparente possible au rayonnement utilisé ou à rendre l'absorption négligeable, dans le cas présent, les conditions du rayonnement, les matériaux choisis et les épaisseurs utilisées sont associées pour s'assurer qu'une partie de l'énergie du rayonnement ne parviendra pas à la seconde paroi principale 3b ni même à une partie de la résine plus ou moins proche de cette seconde paroi principale 3b.

Bien que toute la résine 5 puisse être soumise au rayonnement, seul le volume de résine 5 qui reçoit une énergie supérieure à l'énergie seuil d'insolation de la résine 5 est transformé. De ce fait, une zone non soumise au rayonnement incident ou soumise à un rayonnement pas assez puissant n'est pas considérée comme insolée donc pas transformée. L'énergie seuil d'insolation qui conditionne, le changement de propriété de la résine 5 est modulée au moyen de la résine utilisée et également au moyen des conditions opératoires lors de la formation de la résine, typiquement au moyen des paramètres de couchage de la résine 5, par exemple la température de son recuit pré-insolation.

En choisissant judicieusement l'énergie du rayonnement, le profil d'absorption au fur et à mesure des matériaux traversés et l'énergie seuil d'insolation, il est possible de définir l'épaisseur du revêtement de surface 9 par rapport à la hauteur de la cavité 1. Le profil d'absorption est défini à partir des matériaux traversés et des épaisseurs de ces matériaux. Le profil d'absorption donne sur le passage du rayonnement utilisé (en fonction de l'épaisseur), la proportion de rayonnement disponible par rapport à l'énergie initiale en sortie de la source de rayonnement ou à la surface externe de la structure.

De manière générale, lors de l'irradiation d'un matériau prédéfini au moyen d'un rayonnement électromagnétique connu, la proportion du rayonnement incident qui traverse le matériau est donnée par la relation suivante : $T = e^{\left(\frac{-4\pi.k}{\lambda}.z\right)}$, dans laquelle

$T$ est le coefficient de transmission du matériau traversé à la longueur d'onde désirée,

$\lambda$ est la longueur d'onde du rayonnement électromagnétique,

$k$ est le coefficient d'atténuation du matériau irradié,

$z$ est l'épaisseur du matériau irradié.

Au moyen de l'équation ci-dessus, il est possible de calculer des abaques représentant par exemple, l'évolution du coefficient de transmission à une longueur d'onde prédéfinie pour différentes épaisseurs d'un matériau prédéfini. De tels abaques peuvent être déterminés par exemple au moyen du logiciel XOP qui est disponible à l'adresse internet :

http: //www.esrf.eu/ computing/ scientific/xop2.1/ intro.html.

Pour le rayonnement électronique, le logiciel SKELETON de la société Synopsis ou le logiciel Casino de l'Université de Sherbrooke au Québec peuvent être utilisés.

Dans le calcul du coefficient de transmission global d'une structure, il est nécessaire de prendre en compte l'atténuation engendrée par tous les matériaux traversés par le rayonnement électromagnétique ou électronique. De ce fait, pour la réalisation d'abaques fiables de rayonnement transmis à la première résine, il est nécessaire de prendre au moins en compte l'épaisseur de la première paroi principale 3a, l'épaisseur de la résine 5 et la nature des matériaux qui forment la première paroi principale 3a et la résine 5.

L'énergie d'insolation de la résine 5, l'énergie initiale du rayonnement et l'atténuation à l'intérieur de la structure recherchée sont les paramètres à moduler pour obtenir le profil voulu de résine insolée. Au moyen des abaques, il est possible de définir simplement la corrélation qui existe entre les différentes conditions opératoires citées plus haut.

Une fois certains paramètres imposés, il est possible au moyen des abaques de définir les conditions sur les autres paramètres pour obtenir le revêtement de surface recherché. Lorsque la première paroi principale 3a présente une épaisseur variable, et donc une atténuation qui varie sur l'ensemble de la première paroi principale, le revêtement de surface présente lui aussi une épaisseur variable. En revanche, si la première paroi principale 3a présente une absorption constante sur toute sa surface, la déformation de la première paroi principale 3a ne se répercute pas sur l'épaisseur de la zone insolée. Si la zone insolée forme le futur revêtement de surface 9, ce dernier aura une épaisseur constante qui suivra la déformation de la première paroi principale.

De plus, le coefficient d'atténuation de chacun des matériaux étant variable il est également avantageux de moduler également la longueur d'onde du rayonnement incident afin d'avoir un plus grand choix dans les matériaux et les épaisseurs possibles pour la première paroi principale 3a et la résine 5.

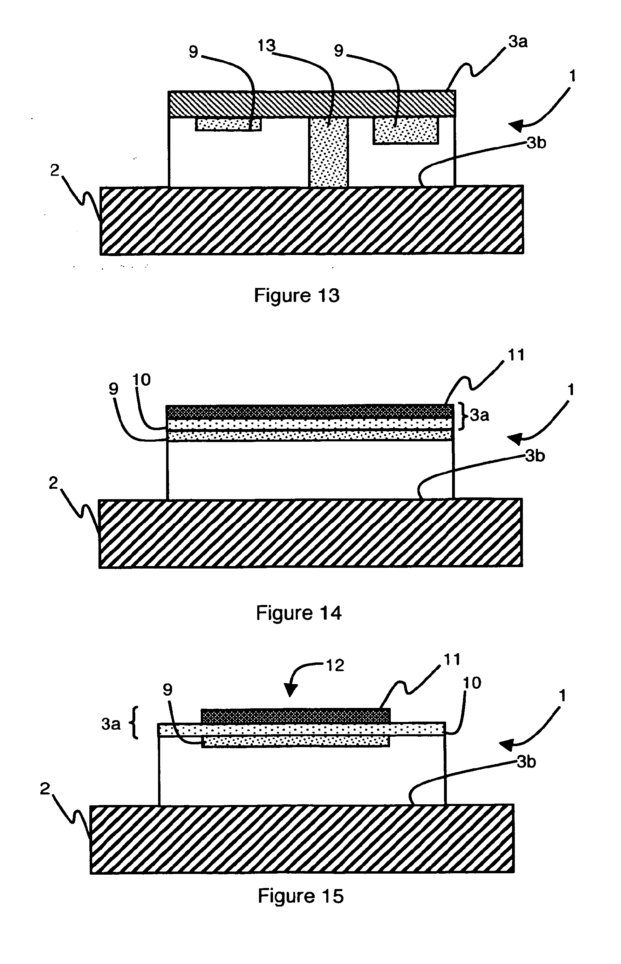

Cependant, dans une variante de réalisation illustrée à la figure 13, il est possible que certains volumes de la résine 5 reliant les deux parois principales 3 selon la direction du rayonnement soient intégralement insolés ou non insolés de manière à former un volume de matériau stable 8, un pilier 13 qui relie les deux parois principales opposées 3. Ces volumes de matériau sont, par exemple, dans le même matériau que le revêtement de surface 9, mais comme expliqué précédemment ils ne jouent pas le rôle de revêtement de surface 9. A titre d'exemple, ces volumes de résine 5 peuvent être utilisés pour améliorer les caractéristiques mécaniques de la cavité 1, pour définir des sous-cavités à l'intérieur de la cavité 1 ou pour limiter la surface effective de la cavité 1.

Le rayonnement électronique est un rayonnement localisé qui est typiquement obtenu par un canon à électrons. Le déplacement du rayonnement électronique permet de délimiter latéralement la zone insolée et donc les dimensions latérales la zone en revêtement de surface. La délimitation de la zone de revêtement de surface est réalisée comme expliquée plus haut, par l'énergie du canon à électron, l'épaisseur de la résine 5 et/ou l'absorption dans la cavité 1.

Le rayonnement électromagnétique présente une longueur d'onde comprise entre 12,5 et 15nm, c'est-à-dire un rayonnement dans l'ultraviolet extrême. Le rayonnement ultraviolet extrême n'est pas localisé. De manière conventionnelle, le rayonnement ultraviolet est émis depuis une source et passe au travers d'un dispositif de contrôle des conditions opératoire et le rayonnement ultraviolet inonde une surface plus ou moins importante. De manière classique, le rayonnement ultraviolet extrême peut être couplé à un masque qui permet de définir les zones à insoler. Le masque présente des zones opaques au rayonnement et des zones transparentes ou partiellement transparentes. Les zones transparentes délimitent latéralement les zones à insoler. Cependant, selon les modes de réalisation, ce masque peut être optionnel. Le masque permet de transformer le rayonnement diffus en un rayonnement localisé.

Les conditions opératoires du rayonnement appliqué à la cavité 1 sont définies de manière à assurer la formation des motifs à la résolution choisie. Dans certains cas, il est difficile d'obtenir un bon contrôle des dimensions latérales et une parfaite maîtrise du profil d'absorption du rayonnement.

Comme illustré à la figure 14, dans les cas où le matériau formant la première paroi principale 3a, c'est-à-dire la couche active 10, est trop transparent pour obtenir le profil recherché de revêtement de surface 9, un matériau de masquage 11 est formé en plus. La première paroi principale 3a comporte alors une couche active 10 et une couche de masquage 11.

Le matériau de la couche de masquage 11 et son épaisseur permettent de moduler l'absorption du rayonnement et donc permettent de définir la profondeur jusqu'à laquelle il y a insolation à l'intérieur de la résine 5.

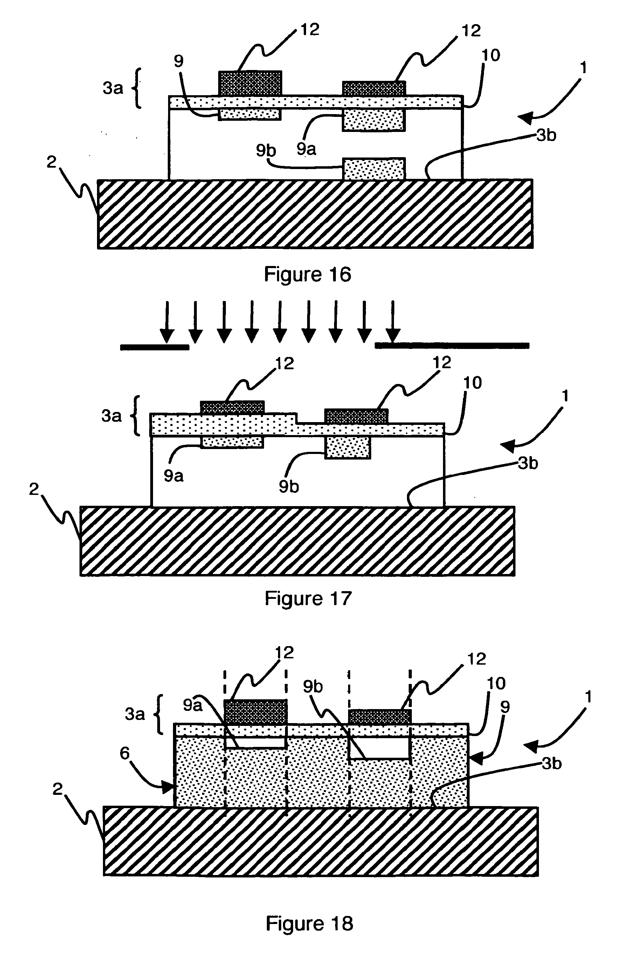

Comme illustré aux figures 15 et 16, en structurant la couche de masquage 11 pour former un masque d'absorption 12, il est possible de former une première paroi principale 3a qui présente un profil d'absorption recherché, un profil d'absorption particulier. En considérant que l'absorption dans la résine 5 et l'absorption dans la couche active 10 sont homogènes dans leurs volumes, la définition du masque d'absorption dans ses épaisseurs et ses constituant permet de contrôler l'épaisseur du futur revêtement de surface 9. La forme du revêtement de surface 9 ne dépend plus que du profil d'absorption du masque d'absorption 12. Le masque d'absorption 12 peut avoir une forme quelconque et être formé par un ou plusieurs motifs disposés sur une même première paroi principale 3a (figure 16).

De cette manière en utilisant un masque d'absorption 12 qui présente un dessin prédéfinie ou une couche de masquage 11, il est possible d'obtenir une première paroi principale 3a qui présente un profil d'atténuation particulier. Si la résine est homogène dans son volume, donc si elle présente un coefficient d'atténuation constant, le profil d'atténuation de la première paroi principale 3a est répercuté dans la résine 5, les premières zones en matériau sacrificiel et les secondes zones en matériau stable 8 reproduisent ce masque.

Il est également avantageux d'utiliser une couche de masquage 11 qui présente un coefficient d'atténuation identique ou proche de celui de la couche active 10. La formation d'une couche de masquage ayant une face libre plane recouvrant la surface structurée de la couche active 10 permet de gommer au moins partiellement la différence d'absorption dans la couche active 10. La zone insolée de la résine présente alors une interface sensiblement plate avec la zone non insolée. Un résultat identique peut être obtenu en utilisant une résine qui a un coefficient d'absorption identique à celui de la première paroi principale 3a.

Dans un premier mode de réalisation (figure 1), l'épaisseur du revêtement de surface 9 est définie au moyen de l'épaisseur de la résine 5. L'épaisseur de résine déposée est faible et laisse dans la cavité 1 un volume vide. Le rayonnement incident modifie les propriétés de la résine 5 sur toute son épaisseur. Le film de résine 5 disposé sur la première paroi principale 3a est traversé par le rayonnement incident et le film présente alors des zones en matériau sacrificiel 7 et des zones en matériau stable 8 sur toute l'épaisseur de résine 5.

Dans ce premier mode de réalisation, les épaisseurs sont faibles, il y a peu d'absorption du rayonnement par les matériaux traversés. Le rayonnement arrive alors jusqu'au film de résine 5 disposé sur la seconde paroi principale 3b et définit des zones en matériau sacrificiel 7 et des zones en matériau stable 8 sur toute l'épaisseur de résine 5.

Deux zones en revêtement de surface 9 sont disposées en regard, de manière symétrique, sur les première 3a et seconde 3b parois principales de la cavité 1 et correspondent au trajet du rayonnement dans la cavité 1. Dans ce cas de figure, l'énergie du rayonnement est suffisante pour insoler deux films distincts en résine 5 sur le trajet du rayonnement (zones 9a et 9b sur la figure 16). Le film de résine 5 a une première épaisseur qui a été complètement insolée au niveau de la première paroi principale 3a. Une deuxième zone de même épaisseur est insolée dans la résine disposée contre la seconde paroi principale 3b. De cette manière, deux zones en revêtement de surface de la même épaisseur sont formées. L'épaisseur de la résine déposée est inférieure à la moitié de la hauteur de la cavité 1 pour laisser une zone vide dans la paroi.

Dans certains cas, il y a dans la cavité un plan de symétrie, ce plan de symétrie est perpendiculaire à l'axe de propagation du rayonnement incident. De manière pratique, si les parois principales sont planes et parallèles et si l'axe de propagation du rayonnement est perpendiculaire à la première paroi principale 3a, le plan de symétrie est parallèle aux parois principales 3 et est disposé à équidistance des parois principales. L'insolation de la résine 5 peut être réalisée au moyen d'une source localisée, au moyen d'une source diffuse qui passe à travers un masque, et/ou au moyen un masque d'absorption 12 former dans la première paroi principale 3a.

Dans un deuxième mode de réalisation (figure 2), la résine 5 est déposée sur les parois principales 3 de la cavité 1 et elle ne remplit pas la cavité. L'énergie du rayonnement est insuffisante pour insoler l'intégralité de la résine 5 se trouvant sur son passage. Il y a alors une différence entre les première 3a et seconde 3b parois principales. La seconde paroi principale 3b présente une surface unie, une surface libre ou une couverture intégrale par le revêtement de surface 9 (figure 12). La première paroi principale 3a peut présenter une surface structurée, une surface présentant simultanément des zones vides et des zones en revêtement de surface, ou une surface unie. Si la seconde paroi principale 3b est libre, la première paroi principale 3a est recouverte par le revêtement de surface 9 soit complètement soit partiellement par au moins un motif. Si la seconde paroi principale 3b est recouverte complètement par le revêtement de surface 9, la première paroi principale 3a est soit libre soit partiellement recouverte par le revêtement de surface 9. Si la seconde paroi principale 3b est recouverte par le matériau stable 8, il peut comporter des zones épaisseurs variables si il a été partiellement insolé par le rayonnement suite à l'insolation complète d'une portion de la résine contre la première paroi principale 3a.

Ce mode de réalisation correspond à plusieurs cas de figures. Dans une première variante de réalisation, le volume restant de la cavité 1 est rempli par un matériau de remplissage 6 qui absorbe le rayonnement incident (figure 4). Les conditions opératoires du rayonnement utilisé sont définies pour que le rayonnement traverse la première paroi principale 3a et insole la résine 5 qui est déposée sur cette première paroi principale 3a. Le rayonnement incident est ensuite absorbé par le matériau de remplissage 6 pour éviter toute insolation parasite de la résine déposée sur la seconde paroi principale 3b. Le matériau de remplissage 6 et les conditions opératoires du rayonnement incident sont donc choisies pour éviter que le rayonnement indicent n'atteigne la résine 5 disposée contre la seconde paroi 3b. La seconde paroi principale 3b est donc intégralement recouverte par le revêtement de surface ou intégralement libre (figures 12, 14, 15 et 17 à 19).

Dans une seconde variante, l'épaisseur de la résine 5 et les conditions opératoires du rayonnement incident sont définies pour que le rayonnement ne traverse pas la résine 5 disposée contre la première paroi principale 3a (figures 3 et 4). Ainsi, seule une partie de l'épaisseur de la résine 5 disposée sur la première paroi principale 3a est insolée et la résine 5 localisée sur la seconde paroi principale 3b n'est pas insolée. Selon la polarité de la résine 5, il est donc possible de définir un revêtement de surface 9 ayant une épaisseur précise inférieure à l'épaisseur de la résine 5 lors de son dépôt dans la cavité. Il est également possible de définir dans la couche de résine 5 un volume vide correspondant au volume insolé si ce dernier est transformé en matériau sacrificiel. Ce volume vide est recouvert par la partie restante du film en résine 5. La seconde paroi principale est donc intégralement recouverte par le revêtement de surface ou intégralement libre (figures 12, 14, 15 et 17 à 19).

Dans une troisième variante, la résine 5 ou une partie de la résine 5 disposée contre la première paroi principale 3a est complètement insolée, mais l'insolation s'arrête dans le volume de résine disposé contre la seconde paroi principale 3b.

Dans les modes de réalisation qui suivent, la résine 5 remplit le volume de la cavité 1. Comme dans les modes de réalisation précédents, il est possible de définir de manière tridimensionnelle, le futur revêtement de surface 9.

Dans un troisième mode de réalisation, illustré aux figures 14 à 19, qui peut être combiné avec le deuxième mode de réalisation, la première paroi principale 3a comporte une couche active 10 et une couche de masquage 11. La couche active 10 est une couche permanente, c'est-à-dire la couche qui définit la surface de la première paroi principale et donc la surface de la cavité 1. La couche de masquage 11 est choisie dans un matériau qui présente avantageusement un coefficient d'atténuation plus important ou identique à celui de la couche active 10. La couche de masquage 11 peut être une couche sacrificielle. La couche de masquage 11 peut être une couche qui recouvre toute la couche active 10 et donc toute la première paroi principale 3a.

Dans un quatrième mode de réalisation, illustré aux figures 13 et 16 à 19, qui peut être combiné avec les second et troisième modes de réalisation, la première paroi principale 3a présente un profil d'absorption variable. La première paroi principale 3a n'a pas une absorption constante sur l'ensemble de sa surface. Cette différence d'absorption peut provenir d'une modulation de l'épaisseur sur la surface (figure 16 à 19) et/ou d'une modulation des matériaux utilisés (figure 13).

Comme illustré aux figures 16 à 19, la couche active 10 et/ou la couche de masquage 11 peuvent présenter des variations d'épaisseur. La couche active 10 et/ou la couche de masquage 11 peuvent présenter des différences de répartitions dans les matériaux utilisés. La couche de masquage 11 peut être structurée afin de former un masque d'absorption 12 (figures 15 à 18). Dans ce deuxième cas, la première paroi principale 3a présente une atténuation qui varie selon la position sur la première paroi principale 3a.

A titre d'exemple illustré aux figures 16 et 18, si la première paroi principale 3a est composée d'une couche active 10 homogène surmontée d'un masque d'absorption 12 formé par deux lignes en matériau de masquage, la résine 5 peut présenter différentes formes après insolation et élimination du matériau sacrificiel 7. Dans un premier exemple (figure 16), la première paroi principale 3a est recouverte par deux zones en revêtement de surface 9, la seconde paroi principale 3b comporte une zone de revêtement 9b. Dans un second exemple (figure 18), la seconde paroi principale 3b est complètement recouverte par le revêtement de surface 9 et la première paroi principale 3a présente deux zones non recouvertes par le revêtement de surface 9 et un pilier 13. Dans ce deuxième exemple, le matériau stable 8 contre la première paroi principale 3a est confondu avec le matériau stable 8 contre la seconde paroi principale 3b pour former des piliers 13. Le revêtement de surface 9 est formé par la surface libre du matériau stable 8 qui est en regard et à distance de la paroi principale opposée, ici la première paroi principale 3a.

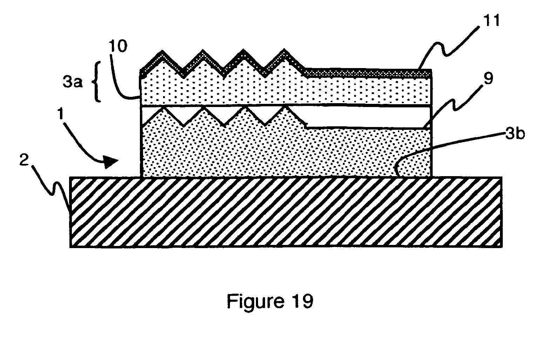

Dans un autre exemple illustré à la figure 19, la première paroi principale 3a présente un profil d'atténuation de forme pyramidale. Ce profil peut être obtenu, par exemple, au moyen d'une couche active 10 présentant une forme pyramidale recouverte par une couche de masquage 11 d'épaisseur constante. L'interface entre les premières zones en matériau sacrificiel 7 et les secondes zones en matériau stable 8 reproduit également le motif de forme pyramidale.

En imposant à la première paroi principale 3a un profil d'atténuation variable en fonction de la position sur la première paroi principale, il est possible de former un revêtement de surface 9 ayant une épaisseur variable prédéfinie.

Ainsi, la forme tridimensionnelle du revêtement de surface 9 dans la cavité 1 est directement liée au profil d'atténuation de la première paroi principale, typiquement il est lié à la forme du masque d'absorption 12 si l'absorption est homogène dans la résine 5. Il est également possible de coupler le profil d'absorption du masque d'absorption 12 avec celui de la couche active 10.

Dans une variante de réalisation, la résine 5 est insolée par le rayonnement électronique ou par le rayonnement extrême ultraviolet au travers d'un masque qui ne reproduit pas le motif du masque d'absorption. Dans ces conditions, la forme du revêtement de surface correspond à l'intersection entre le motif défini par le rayonnement (directement par le faisceau électronique ou au travers d'un masque) et la forme du masque d'absorption (motif 9b de la figure 17).

Les dimensions du revêtement de surface 9 sont contrôlées de manière tridimensionnelle. Le rayonnement qui insole la résine 5 délimite la résine de manière latérale. Le contrôle de l'épaisseur peut être réalisé de deux manières différentes. Dans un premier cas de figure, le rayonnement insole l'intégralité de l'épaisseur de la résine. Dans ce cas de figure, l'épaisseur du rayonnement de surface est contrôlée au moyen de l'épaisseur déposée de résine. Dans un second cas de figure, le rayonnement définit également l'épaisseur de résine 5 qui va délimiter par la suite le revêtement de surface 9. Les conditions opératoires du rayonnement et les matériaux formant la première paroi principale 3a et la résine sont choisies de sorte que le rayonnement s'absorbent partiellement dans la paroi supérieure et la résine et de sorte que la différence entre l'énergie du rayonnement et le seuil d'insolation soit nulle à l'épaisseur recherchée du futur revêtement de surface 9. De cette manière, l'énergie du rayonnement d'insolation est absorbée graduellement au fur et à mesure des matériaux traversés. Ainsi, la première partie de la résine 5 est modifiée par le rayonnement car il possède encore une énergie suffisante et lorsque l'énergie du rayonnement devient inférieure ou égale à l'énergie seuil- d'insolation, la deuxième partie de la résine n'est pas modifiée. Il y a alors superposition dans la résine d'une première zone en matériau sacrificielle et d'une seconde zone en revêtement de surface. Selon la polarité de la résine 5 la première zone en matériau sacrificiel 7 peut être au dessus ou au dessous de la seconde zone en revêtement de surface.

De manière simple, en formant sur la surface extérieure de la première paroi principale 3a un masque d'absorption 12 ayant des dimensions tridimensionnelles contrôlées, il est possible de reproduire cette forme à l'intérieure de la cavité 1 dans la résine 5 au moyen du déplacement de l'interface entre la zone insolée et la zone non insolée.

En formant de manière localisée un revêtement de surface 9 dans la cavité, il devient possible de diminuer l'épaisseur effective entre les deux parois principales 3. A titre d'exemple, si la distance entre les deux parois principales 3 est trop importante il est possible de réduire cette épaisseur en formant un revêtement de surface d'épaisseur contrôlé. Selon la polarité de la résine 5 et le procédé utilisé, il est alors possible de localiser le revêtement de surface sur la première paroi principale 3a et/ou sur la seconde paroi principale 3b. A titre d'exemple, si la première paroi principale 3a est un élément mobile d'un résonateur, il est possible de former un revêtement de surface sur cette première paroi principale 3a. Cet élément mobile va donc voir sa masse modifiée ce qui va se traduire par une modification de sa fréquence de résonance. Il est alors possible de corriger un décalage dans le procédé de réalisation, une fois le résonateur formé.

Dans les cas où la première paroi principale 3a est un élément mobile et risque de se coller à la seconde paroi principale 3b, il est intéressant de former une zone présentant des propriétés de surfaces spécifiques qui empêchent le collage des deux parois. Une fois l'élément mobile formé ou une fois la cavité 1 formée, il suffit de former la résine 5 sur les parois principales 3 de la cavité 1 et d'insoler cette résine 5. Selon les conditions opératoires utilisées, il peut se former une ou deux zones en revêtement de surface 9 qui empêchent tout collage parasite de l'élément mobile. Dans la mesure où l'élément mobile est formé, il est plus facile de délimiter précisément la zone en revêtement de surface 9. Il n'est alors plus nécessaire de prendre en compte les variations du procédé de réalisation car la structure finale est connue. De plus, le procédé étant très simple à mettre en oeuvre, il est facilement intégrable dans le schéma de construction du dispositif pour réparer une structure déficiente ou spécialiser un dispositif par rapport à un autre.

Dans le cas où il est nécessaire de parfaitement contrôler la distance entre les parois principales, il est intéressant de former la couche en revêtement de surface 9 une fois la structure réalisée. Comme précédemment, la structure étant formée, il n'est plus besoin de prendre en compte d'éventuelles variations du procédé de réalisation. Ce mode de réalisation est particulièrement intéressant lorsque l'on souhaite définir un profil d'épaisseur particulier entre les deux parois principales 3.

Dans le cas où la cavité comporte une paire de zones en revêtement de surface 9a et 9b en regard, comme illustré à la figure 18, ces deux zones peuvent définir une zone présentant une mouillabilité particulière et former, par exemple un canal de conduction de liquide.

Dans le cas où le revêtement de surface 9, présente des propriétés optiques particulières par rapport à la paroi principale sur laquelle il est formé, il est intéressant de former un guide d'onde optique. Ce mode de réalisation est particulièrement avantageux car le procédé de formation de la cavité est antérieur au procédé de formation du guide d'onde et on évite la dégradation des propriétés des matériaux constituant le guide d'onde.

Dans un cinquième mode de réalisation qui peut être combiné avec les modes de réalisation précédents, la couche de masquage 11 est dans une seconde résine qui est réactive au rayonnement électronique ou électromagnétique de longueur d'onde comprise entre 12,5 et 15nm ou à un autre rayonnement.

La couche de masquage 11 peut être insolée avant la résine 5 afin de définir le masque d'absorption 12 ou la couche de masquage 11 est insolée en même temps que la résine 5. Selon la polarité des résines utilisées, il est possible de former deux zones sacrificielles ou de délimiter deux zones en revêtement de surface 9 ou une zone en revêtement de surface 9 et une zone sacrificielle 7.

Lorsque la couche de masquage 11 est insolée préalablement à la résine 5, le masque d'absorption 12 formé par seconde résine est utilisé de la même manière que précédemment.

A titre d'exemple, cette configuration est particulièrement avantageuse pour la réalisation d'un transistor à double grilles dont le canal est constitué par la couche active 10. Dans ce cas de figure, les grilles de ce transistor sont disposées de part et d'autre du canal, c'est-à-dire de la couche active 10.

Les deux couches en résine 5 sont ensuite soumises, à travers un masque d'insolation, au moyen d'un rayonnement électromagnétique qui a une longueur d'onde prédéfinie comprise entre 12,5 et 15nm et, de préférence, égale à 13,5nm. De cette manière, au moyen du masque, l'ensemble des motifs de la puce est défini en une seule fois, lors de la réaction des couches en résine avec le rayonnement électromagnétique.

La nature et l'épaisseur de la seconde couche en résine et de la première paroi principale 3a sont choisies de manière à laisser passer une quantité suffisante de photons jusqu'à la résine 5. Pour que deux zones insolées soient définis respectivement dans chaque résine de part et d'autre de la première paroi principale 3a et avec les mêmes dimensions latérales. Il est nécessaire que la transmission du rayonnement électromagnétique au travers de la seconde couche en résine et du film 1 en matériau semi-conducteur soit au moins égale à 50%, de préférence au moins égale à 80%.

A titre d'exemple, si la première paroi principale 3a est en matériau semi-conducteur, elle est en silicium ou à base de silicium, par exemple SiC ou un alliage de SiGe. La longueur d'onde du rayonnement électromagnétique est avantageusement choisie égale à 13,5nm. En effet, la première paroi principale 3a présente alors un coefficient d'atténuation k qui est très faible à la longueur d'onde choisie. Il est cependant nécessaire que l'épaisseur de la première paroi principale 3a soit inférieure à une épaisseur critique prédéterminée afin d'assurer le passage du rayonnement avec une énergie suffisante pour faire réagir la résine 5. L'épaisseur critique peut être, par exemple, établie à partir du logiciel XOP en tenant compte du coefficient d'atténuation des matériaux déjà traversés par le rayonnement électromagnétique et de l'absorption dans la résine.

Dans un autre mode de réalisation, la résine 5 a une polarité inverse à celle de la couche de masquage 11 ce qui permet de former dans la cavité au niveau de la seconde paroi principale 3b une zone vide. Si la résine a des propriétés diélectriques proches ou meilleurs que celles de l'oxyde de silicium, la structure obtenue est une de type substrat sur isolant avec un diélectrique enterré a épaisseur variable. Si le masque d'absorption 12 sert de grille ou pour délimiter la grille d'un transistor, il y a un spécifiquement sous la grille et de manière auto-alignée un diélectrique enterré qui présente des propriétés différentes du diélectrique enterré disposé au niveau des zones de source et de drain.

Avantageusement, si le film 1 est en silicium, son épaisseur est comprise entre 5 et 25nm, de manière encore plus avantageuse, l'épaisseur est de l'ordre de 10nm.

De manière générale, la première paroi principale 3a est en matériau semi-conducteur et avantageusement en silicium ou en matériau à base de silicium tel que SiC ou les alliages de SiGe. La première paroi principale 3a peut également être en germanium ou en alliage semi-conducteur de type III-V ou II-VI, tels que par exemple AsGA, InP, CdTe, ZnTe. La première paroi principale peut également être en métal ou en matériau isolant. Selon les propriétés de la première paroi principale 3a, l'un des deux types de rayonnement peut ne pas être adapté.

Dans un mode de réalisation particulier, l'épaisseur de la cavité est typiquement égale à 20nm, l'épaisseur du film 1 est de l'ordre de 10nm et l'épaisseur du film en seconde résine est inférieure ou égale à 50nm.

Les résines sont développées, par exemple, avec une solution à base de TMAH (Tetramethylammonium hydroxide).

Dans ces modes de réalisation, il est possible de former une pluralité de zones en revêtement de surface 9 sur une paroi principale 3 ou une pluralité de paires de zones en revêtement de surface. Les paires de zones sont formées par deux zones en revêtement de surface 9 qui ont des dimensions latérales identiques et qui sont autoalignées dans la cavité 1 (figure 16). Les zones en revêtement de surface sont formées par une pluralité d'insolation ou par une même étape d'insolation comportant un masque ayant une pluralité de zones transparentes.

Dans un sixième mode de réalisation qui peut s'appliquer aux modes de réalisation précédentes, la cavité comporte une pluralité de zones en revêtements de surface 9 différents. Les différents revêtements de surface 9 sont formés successivement. Ainsi, une première résine 5 associée à un premier revêtement de surface est déposée dans la cavité 1. Cette première résine 5 est insolée pour former un premier matériau sacrificiel 7 et délimiter un premier revêtement de surface. Une fois le premier matériau sacrificiel 7 éliminé et le premier revêtement de surface formé, une seconde résine est déposée dans la cavité et insolée pour former un second matériau sacrificiel et définir un second revêtement de surface. De la même manière, il devient possible de former successivement différents revêtements de surface 9 associés chacun à une zone ou à une paire de zones. Les différents revêtements de surface 9 peuvent présenter entre eux une épaisseur variable au sein de la cavité 1.

La cavité 1 est ainsi partiellement recouverte par au moins une zone en revêtement de surface 9. La résine 5 qui délimite la zone en revêtement de surface 9 est choisie en fonction de particularités physico-chimiques, optiques, mécaniques et de son aptitude à réagir au rayonnement incident.

La résine 5 est par exemple une résine organique qui réagit au rayonnement utilisé (électronique ou électromagnétique), mais elle peut également être une résine non organique. La résine peut être également une monocouche auto-assemblée (SAM, Self Assembled Monolayer en anglais) qui peut présenter des propriétés de surface intéressante d'un point de vue électrique.

La résine 5 est avantageusement en HSQ (hydrogen silsesquioxane) qui peut être recuite pour former par la suite un oxyde.

Le matériau du revêtement de surface peut également être un matériau catalyseur pour la croissance de nanotubes ou de nanofils ou un matériau électriquement conducteur qui permet une croissance postérieure par dépôt électrochimique.

Il est également envisageable de remplir la cavité une fois le revêtement e surface formé. A titre d'exemple, la cavité peut être formée par des matériaux présentant des propriétés diélectriques différentes (deux matériaux isolants ou un matériau isolant et un matériau électriquement conducteur) ce qui peut permettre de canaliser les lignes de champs dans la cavité.

**Revendications**

1. Procédé de réalisation d'une cavité (1) ayant des première (3a) et seconde (3b) parois principales opposées, l'une des parois principales (3) étant au moins partiellement recouverte par un revêtement de surface (9) de taille submicronique ayant une face libre, procédé **caractérisé en ce qu'**il comporte :

   - la formation de la cavité (1) avec ses deux parois principales (3) recouvertes par une résine (5),
   - l'insolation de la résine (5) sur une première épaisseur par un rayonnement, au travers de la première paroi principale (3a), pour former dans la résine (5) une première zone en matériau sacrificiel (7) et une seconde zone de nature différente (8), l'une des première et seconde zones définissant l'aire du futur revêtement de surface (9),
   - l'élimination du matériau sacrificiel (7) et la formation du revêtement de surface (9) contre une des parois principales (3).

2. Procédé selon la revendication 1, **caractérisé en ce que** les première et seconde zones sont superposées.

3. Procédé selon l'une des revendications 1 et 2, **caractérisé en ce que** la source de rayonnement délivre un rayonnement de type électronique ou de type électromagnétique de longueur d'onde comprise entre 12,5 et 15nm.

4. Procédé selon l'une quelconque des revendications 1 à 3, **caractérisé en ce que** la paroi principale supérieure (3a) comporte une couche active (10) et une couche de masquage (11) sacrificielle.

5. Procédé selon la revendication 4, **caractérisé en ce que** la couche de masquage (11) est structurée pour former un masque d'absorption (12), la première paroi principale (3a) présentant un profil d'absorption du rayonnement variable.

6. Procédé selon l'une des revendications 4 et 5, **caractérisé en ce que** la couche de masquage (11) est une résine sensible au dit rayonnement.

7. Procédé selon l'une quelconque des revendications 1 à 6, **caractérisé en ce que** le revêtement de surface (9) présente une épaisseur variable.

8. Procédé selon l'une quelconque des revendications 1 à 7, **caractérisé en ce que** l'épaisseur de la résine (5) est égale à la première épaisseur.

9. Procédé selon l'une quelconque des revendications 1 à 7, **caractérisé en ce que** la résine (5) remplit la cavité.

10. Procédé selon la revendication 1 à 8, **caractérisé en ce qu'**un matériau de remplissage (6) absorbant le rayonnement incident est disposé dans la cavité (1).

11. Procédé selon l'une quelconque des revendications 1 à 10, **caractérisé en ce que** la résine (5) forme le revêtement de surface (9).

12. Procédé selon l'une quelconque des revendications 1 à 10, **caractérisé en ce que** la résine (5) est soumise à un traitement thermique pour former le revêtement de surface (9).

13. Procédé selon l'une quelconque des revendications 2 à 10, **caractérisé en ce que** le revêtement de surface (9) est formé dans la première zone.

**Claims**

1. A method for forming a cavity (1) having opposite first (3a) and second (3b) main walls, one of the main walls (3) being at least partially covered by a surface coating (9) of submicronic size having a free surface, method **characterized in that** it comprises:

   - formation of the cavity (1) with its two main walls (3) covered by a resist (5),
   - exposure of the resist (5) over a first thickness by radiation, through the first main wall (3a), to form in the resist (5) a first area of sacrificial material (7) and a second area of different nature (8), one of the first and second areas defining the area of the future surface coating (9),
   - removal of the sacrificial material (7) and formation of the surface coating (9) against one of the main walls (3).

2. The method according to claim 1, **characterized in that** the first and second areas are superposed.

3. The method according to one of claims 1 and 2, **characterized in that** the radiation source delivers a radiation of electronic type or of electromagnetic type of wavelength comprised between 12.5nm and 15nm.

4. The method according to any one of claims 1 to 3, **characterized in that** the top main wall (3a) comprises an active layer (10) and a sacrificial masking layer (11).

5. The method according to claim 4, **characterized in that** the masking layer (11) is patterned to form an absorption mask (12), the first main wall (3a) presenting a variable radiation absorption profile.

6. The method according to one of claims 4 and 5, **characterized in that** the masking layer (11) is a resist sensitive to said radiation.

7. The method according to any one of claims 1 to 6, **characterized in that** the surface coating (9) presents a variable thickness.

8. The method according to any one of claims 1 to 7, **characterized in that** the first exposed thickness of resist (5) is equal to the thickness of said resist (5).

9. The method according to any one of claims 1 to 7, **characterized in that** the resist (5) fills the cavity.

10. The method according to any one of claims 1 to 8, **characterized in that** a filling material (6) absorbing the incident radiation is arranged in the cavity (1).

11. The method according to any one of claims 1 to 10, **characterized in that** the resist (5) forms the surface coating (9).

12. The method according to any one of claims 1 to 10, **characterized in that** the resist (5) is subjected to heat treatment to form the surface coating (9).

13. The method according to any one of claims 2 to 10, **characterized in that** the surface coating (9) is formed in the first area.

**Patentansprüche**

1. Verfahren zur Herstellung eines Hohlraums (1), der eine erste (3a) und eine zweite (3b) Hauptwand, die einander gegenüberliegen, aufweist, wobei die eine der Hauptwände (3) wenigstens teilweise mit einer Oberflächenbeschichtung (9) mit Submikrongröße, die eine freie Fläche aufweist, überzogen ist, Verfahren, welches **dadurch gekennzeichnet ist, dass** es umfasst:

- das Ausbilden des Hohlraums (1) mit seinen beiden mit einem Harz (5) überzogenen Hauptwänden (3),

- das Bestrahlen des Harzes (5) über eine erste Dicke mittels einer Strahlung, durch die erste Hauptwand (3a) hindurch, um in dem Harz (5) einen ersten Bereich aus Opfermaterial (7) sowie einen zweiten Bereich anderer Art (8) zu bilden, wobei der eine der ersten und zweiten Bereiche die Fläche der zukünftigen Oberflächenbeschichtung (9) definiert,
- das Entfernen des Opfermaterials (7) und das Ausbilden der Oberflächenbeschichtung (9) an einer der Hauptwände (3).

2. Verfahren nach Anspruch 1, **dadurch gekennzeichnet, dass** der erste und der zweite Bereich übereinander liegen.

3. Verfahren nach einem der Ansprüche 1 und 2, **dadurch gekennzeichnet, dass** die Strahlungsquelle eine Strahlung elektronischer Art oder elektromagnetischer Art mit einer Wellenlänge im Bereich zwischen 12,5 und 15 nm liefert.

4. Verfahren nach einem der Ansprüche 1 bis 3, **dadurch gekennzeichnet, dass** die obere Hauptwand (3a) eine aktive Schicht (10) und eine Opfermaskierungsschicht (11) umfasst.

5. Verfahren nach Anspruch 4, **dadurch gekennzeichnet, dass** die Maskierungsschicht (11) strukturiert ist, um eine Absorptionsmaske (12) zu bilden, wobei die erste Hauptwand (3a) ein Profil zur Absorption der veränderlichen Strahlung aufweist.

6. Verfahren nach einem der Ansprüche 4 und 5, **dadurch gekennzeichnet, dass** die Maskierungsschicht (11) ein gegenüber der Strahlung empfindliches Harz ist.

7. Verfahren nach einem der Ansprüche 1 bis 6, **dadurch gekennzeichnet, dass** die Oberflächenbeschichtung (9) eine veränderliche Dicke aufweist.

8. Verfahren nach einem der Ansprüche 1 bis 7, **dadurch gekennzeichnet, dass** die Dicke des Harzes (5) gleich der ersten Dicke ist.

9. Verfahren nach einem der Ansprüche 1 bis 7, **dadurch gekennzeichnet, dass** das Harz (5) den Hohlraum ausfüllt.

10. Verfahren nach Anspruch 1 bis 8, **dadurch gekennzeichnet, dass** ein Füllmaterial (6), das die einfallende Strahlung absorbiert, in dem Hohlraum (1) angeordnet ist.

11. Verfahren nach einem der Ansprüche 1 bis 10, **dadurch gekennzeichnet, dass** das Harz (5) die Oberflächenbeschichtung (9) bildet.

**12.** Verfahren nach einem der Ansprüche 1 bis 10, **dadurch gekennzeichnet, dass** das Harz (5) einer Wärmebehandlung unterzogen wird, um die Oberflächenbeschichtung (9) zu bilden.

**13.** Verfahren nach einem der Ansprüche 2 bis 10, **dadurch gekennzeichnet, dass** die Oberflächenbeschichtung (9) in dem ersten Bereich ausgebildet ist.

Figure 1

Figure 2

Figure 3

Figure 4

Figure 5

Figure 6

Figure 7

Figure 8

Figure 9

Figure 10

Figure 11

Figure 12

Figure 13

Figure 14

Figure 15

Figure 16

Figure 17

Figure 18

Figure 19

**EP 2 332 882 B1**

**RÉFÉRENCES CITÉES DANS LA DESCRIPTION**

**Documents brevets cités dans la description**

- US 2004265182 A1